(19) Europäisches Patentamt
European Patent Office
Office européen des brevets

(11) **EP 4 373 120 A1**

(12) **EUROPEAN PATENT APPLICATION**

(43) Date of publication:
**22.05.2024 Bulletin 2024/21**

(21) Application number: **23206988.0**

(22) Date of filing: **31.10.2023**

(51) International Patent Classification (IPC):
*H04N 23/67* (2023.01)    *H01L 27/146* (2006.01)
*H04N 25/13* (2023.01)    *H04N 25/704* (2023.01)
*H04N 25/778* (2023.01)    *H04N 25/79* (2023.01)
*H04N 25/78* (2023.01)    *H04N 25/589* (2023.01)
*H04N 25/616* (2023.01)    *H04N 25/771* (2023.01)

(52) Cooperative Patent Classification (CPC):
**H04N 25/134; H01L 27/14609; H01L 27/14621;
H01L 27/14627; H01L 27/14636; H01L 27/14641;
H04N 23/672; H04N 25/589; H04N 25/616;
H04N 25/704; H04N 25/771; H04N 25/778;
H04N 25/78; H04N 25/79;** H04N 25/11

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **18.11.2022 JP 2022184971**

(71) Applicant: **CANON KABUSHIKI KAISHA**
**Tokyo 146-8501 (JP)**

(72) Inventors:
• **WAKASHIMA, Shunichi**
**Tokyo, 146-8501 (JP)**
• **FUKUDA, Koichi**
**Tokyo, 146-8501 (JP)**

(74) Representative: **TBK**
**Bavariaring 4-6**
**80336 München (DE)**

(54) **IMAGE SENSOR AND IMAGE CAPTURING APPARATUS**

(57) An image sensor includes a plurality of pixels, and each pixel comprises: a microlens; a plurality of photoelectric conversion units that convert incident light into charge and accumulate the charge; a plurality of holding units that hold signals corresponding to the charge; control means configured to control timings of accumulating the charge converted by the plurality of photoelectric conversion units and timings of causing the plurality of holding units to hold the signals corresponding to the charge; and output means configured to output the signals held in the plurality of holding units in units of one row. The plurality of pixels include a plurality of first pixels having the plurality of photoelectric conversion units arranged in a first direction and a plurality of second pixels having the plurality of photoelectric conversion units arranged in a second direction which is perpendicular to the first direction.

FIG. 3

EP 4 373 120 A1

**Description**

BACKGROUND OF THE INVENTION

Field of the Invention

The present invention relates to an image sensor in which pixel units each having a plurality of photoelectric conversion units are two-dimensionally arranged, and an image capturing apparatus equipped with the image sensor.

Description of the Related Art

As one of focus detection methods performed in an image capturing apparatus, a so-called on-imaging plane phase difference method in which a pair of pupil division signals are obtained using focus detection pixels formed in an image sensor and phase difference focus detection is performed using the pair of pupil division signals is known.

As an example of such an on-imaging plane phase difference method, an image capturing apparatus using a two-dimensional image sensor in which one microlens and a plurality of divided photoelectric conversion units are formed for each pixel is disclosed in Japanese Patent Laid-Open No. 58-24105. The plurality of photoelectric conversion units are configured to receive light transmitted through different regions of the exit pupil of an imaging lens via one microlens to realize pupil division. By calculating the image shift amount using the phase difference signals, which are the signals of the respective photoelectric conversion units, phase difference focus detection can be performed. Further, an image can be acquired from an image signal obtained by adding the signals from the individual photoelectric conversion units for each pixel.

In such an image sensor, in a configuration in which a plurality of photoelectric conversion units are arranged in the horizontal direction within a pixel and thus the pupil division direction is the horizontal direction, in a case where a subject has horizontal stripes, for example, parallax is less likely to appear, which may cause a decrease in focus detection accuracy.

To address this problem, Japanese Patent Laid-Open No. 2011-53519 discloses a technique for improving focus detection accuracy by arranging pairs of the photoelectric conversion units arranged under respective microlenses of the focus detection pixels in two directions to make the pupil division directions to two.

On the other hand, in technical field of a CMOS image sensor, a backside illumination technology that receives light on the side opposite to the side on which the pixel circuit is formed, and a technology that laminates semiconductor substrates to form a laminated structure in the backside illumination type CMOS image sensor are in progress. Japanese Patent Laid-Open No. 2021-68758 discloses an example in which capacitors for accumulating pixel signals are provided, using this laminated structure, on a semiconductor substrate different from the semiconductor substrate on which the pixel circuit is formed, thereby providing a global shutter function.

Further, Japanese Patent Laid-Open No. 2021-68758 discloses phase difference detection pixels whose division directions are vertical and phase difference detection pixels whose division directions are horizontal.

However, in Japanese Patent Laid-Open No. 2021-68758, there is no disclosure about arranging both the phase difference detection pixels whose division direction is vertical and the phase difference detection pixels whose division direction is horizontal in the same solid-state imaging device. In the case of an object having luminance fluctuation in the division direction, focus detection accuracy will be degraded. Further, even if the pupil division directions are two as in Japanese Patent Laid-Open No. 2011-53519, in the pixel configuration of Japanese Patent Laid-Open No. 2021-68758, the isolation region in each pixel is large, so sufficient light reception area cannot be secured, and if the object is dark, it is conceivable that the accuracy of focus detection will decrease.

SUMMARY OF THE INVENTION

The present invention has been made in consideration of the above situation, and further enhances focus detection accuracy in different pupil division directions.

The present invention in its first aspect provides an image sensor as specified in claims 1 to 10.

The present invention in its second aspect provides an image capturing apparatus as specified in claim 11.

Further features of the present invention will become apparent from the following description of exemplary embodiments (with reference to the attached drawings).

BRIEF DESCRIPTION OF THE DRAWINGS

The accompanying drawings, which are incorporated in and constitute a part of the specification, illustrate embodiments of the invention, and together with the description, serve to explain the principles of the invention.

FIG. 1 is a diagram schematically showing an overall configuration of an image sensor according to a first embodiment of the present invention;
FIG. 2 is a diagram schematically showing an arrangement of pixels in a stacked image sensor according to the first embodiment;
FIG. 3 is an equivalent circuit diagram of $2\times2$ pixels according to the first embodiment;

FIGS. 4A and 4B illustrate a timing chart showing actuation timings of the image sensor according to the first embodiment;

FIG. 5 illustrates a timing chart showing timings for reading out signals from MEMIC-side pixels to column circuits according to the first embodiment;

FIG. 6 illustrates a timing chart showing a row of pixels and schematic timings at which each operation is performed according to the first embodiment;

FIG. 7 is a schematic diagram showing a basic layout of elements forming a PDIC-side pixel according to the first embodiment;

FIGS. 8A to 8C are cross-sectional views schematically showing cross-sectional structures of a pixel shown in FIG. 7 according to the first embodiment;

FIGS. 9A to 9D are cross sectional plan views of the pixel shown in FIGS. 8A to 8C according to the first embodiment, viewed from above for each depth in a z direction;

FIG. 10 is a cross-sectional view schematically showing a cross-sectional structure of the pixel shown in FIG. 7 according to the first embodiment;

FIGS. 11A to 11C are schematic diagrams showing horizontally divided pixels according to the first embodiment;

FIGS. 12A to 12C are schematic diagrams showing vertically divided pixels according to the first embodiment;

FIG. 13 is diagrams schematically showing an arrangement of horizontally divided pixels and vertically divided pixels and an arrangement of color filters in a range of 2×2 pixels according to the first embodiment;

FIG. 14 is schematic diagrams showing a basic layout of elements constituting MEMIC-side pixels according to the first embodiment;

FIG. 15 is a cross-sectional view schematically showing a cross-sectional structure of the pixel shown in FIG. 14 according to the first embodiment;

FIG. 16 is a block diagram showing a schematic configuration of an image capturing apparatus according to the first embodiment;

FIG. 17 is diagrams showing the relationship between horizontally divided pixels and partial pupil regions according to the first embodiment;

FIG. 18 is a conceptual diagram showing an example of a pupil intensity distribution of partial pupil regions according to the first embodiment;

FIG. 19 is a diagram for schematically explaining a sensor entrance pupil of the image sensor according to the first embodiment;

FIG. 20 is a diagram showing a schematic relationship between an image shift amount between parallax images and a defocus amount according to the first embodiment;

FIG. 21 is an equivalent circuit diagram of a pixel according to a second embodiment;

FIG. 22 is a diagram schematically showing an arrangement of horizontally divided pixels and vertically divided pixels and an arrangement of color filters in a range of 2×2 pixels according to the second embodiment; and

FIG. 23 is a diagram schematically showing an arrangement of horizontally divided pixels and vertically divided pixels and an arrangement of color filters in a range of 4×4 pixels according to a third embodiment.

DESCRIPTION OF THE EMBODIMENTS

Hereinafter, embodiments will be described in detail with reference to the attached drawings. Note, the following embodiments are not intended to limit the scope of the claimed invention, and limitation is not made to an invention that requires a combination of all features described in the embodiments. Two or more of the multiple features described in the embodiments may be combined as appropriate. Furthermore, the same reference numerals are given to the same or similar configurations, and redundant description thereof is omitted.

<First Embodiment>

[Overall Configuration of Image Sensor]

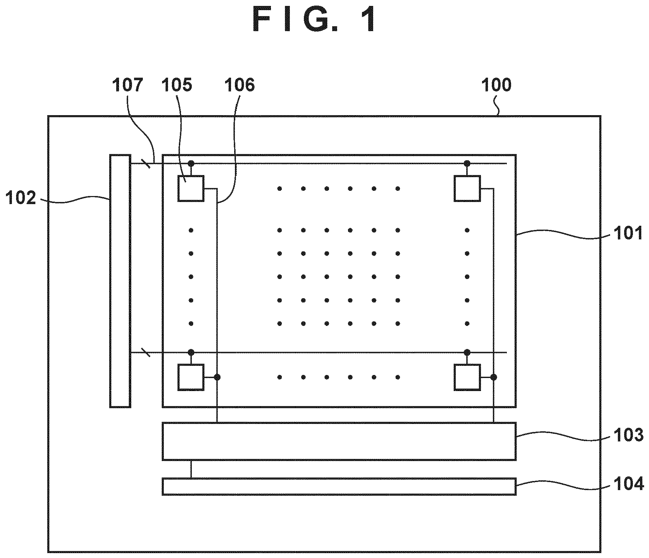

FIG. 1 is a diagram schematically showing the overall configuration of an image sensor 100 according to a first embodiment of the present invention. The image sensor 100 includes a pixel array portion 101 (pixel section), a vertical selection circuit 102, a column circuit 103 and a horizontal selection circuit 104.

A plurality of pixels 105 are arranged in a matrix in the pixel array portion 101. By inputting the output of the vertical selection circuit 102 to the pixels 105 via pixel actuation wirings 107, the pixel signals of the pixels 105 in the row selected by the vertical selection circuit 102 are read out to the column circuit 103 via output signal lines 106. One output signal line 106 may be provided for each pixel column or for a plurality of pixel columns, or a plurality of output signal lines may be provided for each pixel column. A column circuit 103 receives signals read out in parallel via the plurality of output signal lines 106, performs processing such as signal amplification, noise reduction, and A/D conversion, and holds the processed signals. The horizontal selection circuit 104 sequentially, randomly, or simultaneously selects the signals held in the column circuit 103, so that the selected signals are output to the outside of the image sensor 100 via a horizontal output line and an output unit (both not shown).

By sequentially performing the operation of outputting the pixel signals of the row selected by the vertical selection circuit 102 to the outside of the image sensor 100 while changing the row selected by the vertical selection circuit 102, two-dimensional image signal or focus detection signals can be read out.

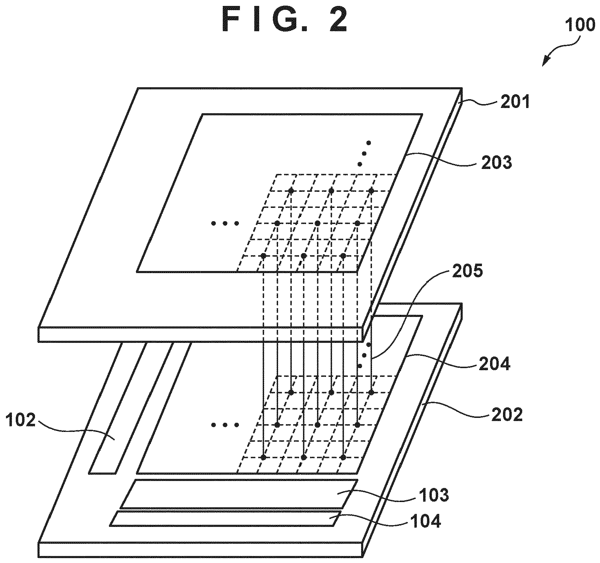

FIG. 2 is a diagram schematically showing an arrangement of pixels when the image sensor 100 according to this embodiment has a stacked structure. The image sensor 100 includes a semiconductor substrate 201 (referred to as "PDIC", hereinafter) disposed on the light incident side and a semiconductor substrate 202 (referred to as "MEMIC", hereinafter) disposed on the opposite side of the light incident side, and of the pixel array portion 101, the portion arranged on the PDIC 201 is called a PDIC-side pixel region 203, and the portion arranged on the MEMIC 202 is called a MEMIC-side pixel region 204. The PDIC-side pixel region 203 and the MEMIC-side pixel region 204 are connected by electrical contacts (HB) 205 arranged for every 2×2 pixels. Note that the HB 205 may be arranged, for example, for each pixel, or may be arranged for every 4×4 pixels, and the present invention is not limited to the manner of arrangement. In FIG. 2, the PDIC 201 and the MEMIC 202 are shown separated from each other for easy understanding of the configuration, but in reality, the semiconductor substrates are configured to be in contact with each other.

[Circuit Configuration of Pixel]

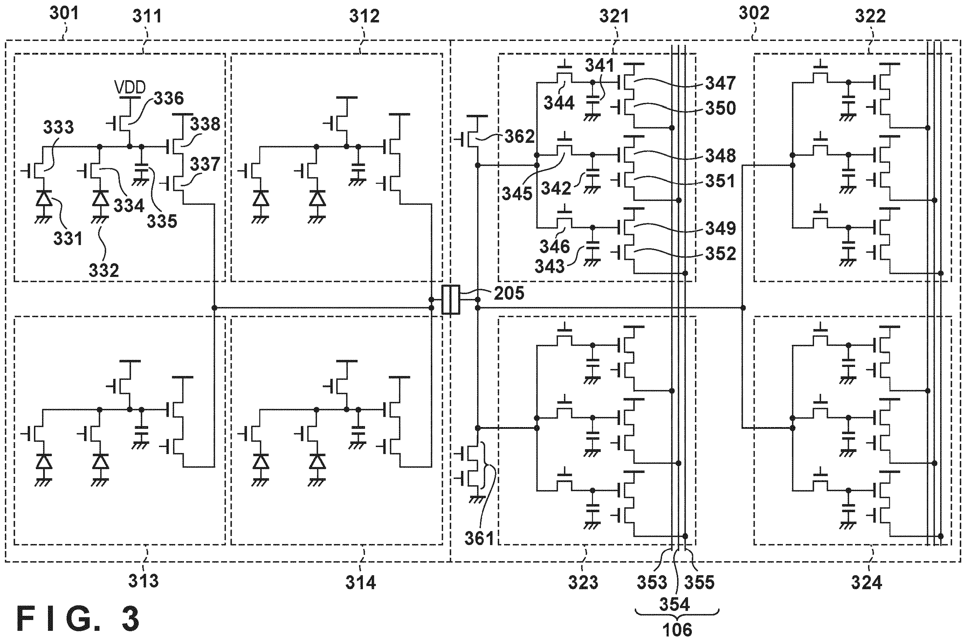

FIG. 3 is an equivalent circuit diagram of the pixels 105 included in the range of 2×2 pixels in this embodiment.

Of the pixels 105 included in the range of 2×2 pixels, reference numeral 301 indicates the portion included in the PDIC-side pixel region 203 and reference numeral 302 indicates the portion included in the MEMIC-side pixel region 204. Moreover, each set of a PDIC-side pixel 311 and a MEMIC-side pixel 321, a PDIC-side pixel 312 and a MEMIC-side pixel 322, a PDIC-side pixel 313 and a MEMIC-side pixel 323, and a PDIC-side pixel 314 and a MEMIC-side pixel 324 constitutes each pixel 105.

Next, the configuration of the pixel 105 will be described by taking the PDIC-side pixel 311 and the MEMIC-side pixel 321 as representative examples. The PDIC-side pixels 312 to 314 and the MEMIC-side pixels 322 to 324 also have the same circuit configuration as that of the PDIC-side pixel 311 and the MEMIC-side pixel 321.

The PDIC-side pixel 311 has a photodiode (PDA) 331 and a photodiode (PDB) 332, which are two photoelectric conversion units. The signal charge photoelectrically converted by the PDA 331 according to the amount of incident light and accumulated is transferred via a transfer transistor (TXA) 333 to a charge-voltage converter (FD) 335 for conversion into voltage. Further, the signal charge photoelectrically converted and accumulated by the PDB 332 is transferred to the FD 335 via the transfer transistor (TXB) 334. When the reset transistor (RES) 336 is turned on, the FD 335 is reset to the voltage of a constant voltage source VDD. Also, by turning on the RES 336 and the TXA 333 and TXB 334 at the same time, the PDA 331 and PDB 332 can be reset.

When a selection switch (SEL) 337 that selects the PDIC-side pixel 311 is turned ON, an amplification transistor (SF) 338 converts the signal charge accumulated in the FD 335 into voltage, and outputs the converted signal voltage from the PDIC-side pixel 311 to the MEMIC-side pixel 321. The gates of the TXA 333, TXB 334, RES 336 and SEL 337 are connected to corresponding pixel actuation wirings 107 and controlled by the vertical selection circuit 102.

In the following description, in this embodiment, the signal charge accumulated in the photoelectric conversion unit is assumed to be electrons, and the photoelectric conversion unit is formed of an N-type semiconductor and separated by a P-type semiconductor. Alternatively, the signal charge to be accumulated may be holes, and the photoelectric conversion unit may be formed of a P-type semiconductor and separated by an N-type semiconductor.

In the MEMIC-side pixel 321, a constant current source (CS) 361 supplies a constant current when outputting a signal from the SF 338. The MEMIC-side pixel 321 also has a signal holding capacitor (MEMN) 341, a signal holding capacitor (MEMA) 342, and a signal holding capacitor (MEMB) 343 for holding the output signal voltages of the PDIC-side pixel 311. The MEMIC-side pixel 321 is further provided with a selection switch (GSN) 344, a selection switch (GSA) 345, and a selection switch (GSB) 346 for selecting the MEMN 341, MEMA342, and MEMB 343, respectively.

Then, when a signal holding capacitor selection transistor (MSELN) 350 is turned on, the voltage signal of the MEMN 341 is output to an output signal line 353 via an amplification transistor (MSFN) 347. Similarly, when a signal holding capacitor selection transistor (MSELA) 351 is turned on, the voltage signal of the MEMA 342 is output to an output signal line 354 via an amplification transistor (MSFA) 348. Further, when a signal holding capacitor selection transistor (MSELB) 352 is turned on, the voltage signal of the MEMB 343 is output to an output signal line 355 via an amplification transistor (MSFB) 349. Note that the output signal lines 353 to 355 correspond to the output signal line 106 shown in FIG. 1.

Further, outside the MEMIC-side pixel 321, a reset transistor (MRES) 362 for resetting the MEMN 341, MEMA 342, and MEMB 343 of the MEMIC-side pixels 321 to 324 is configured.

[Readout Operation of Pixel Signal]

The readout operation of pixel signals in this embodiment includes a signal readout operation from the PDIC-side pixels to the MEMIC-side pixels performed simultaneously in the entire pixel array portion 101, and a signal readout operation from the MEMIC-side pixels in the selected row to the column circuit 103 which is sequentially performed while changing the row selected by the vertical selection circuit 102.

• Signal Readout Operation from PDIC-Side Pixels to MEMIC-Side Pixels

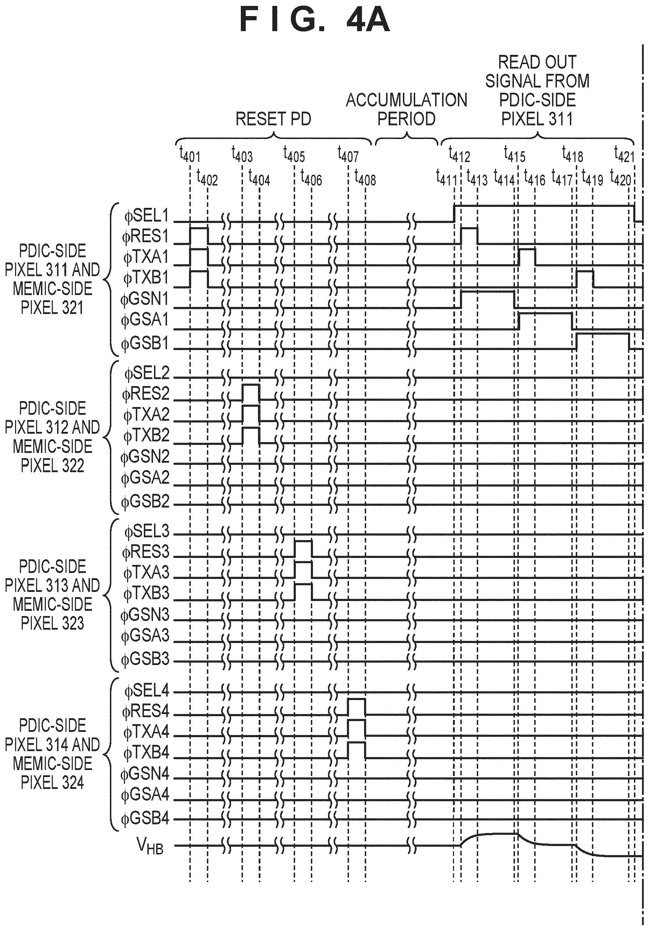

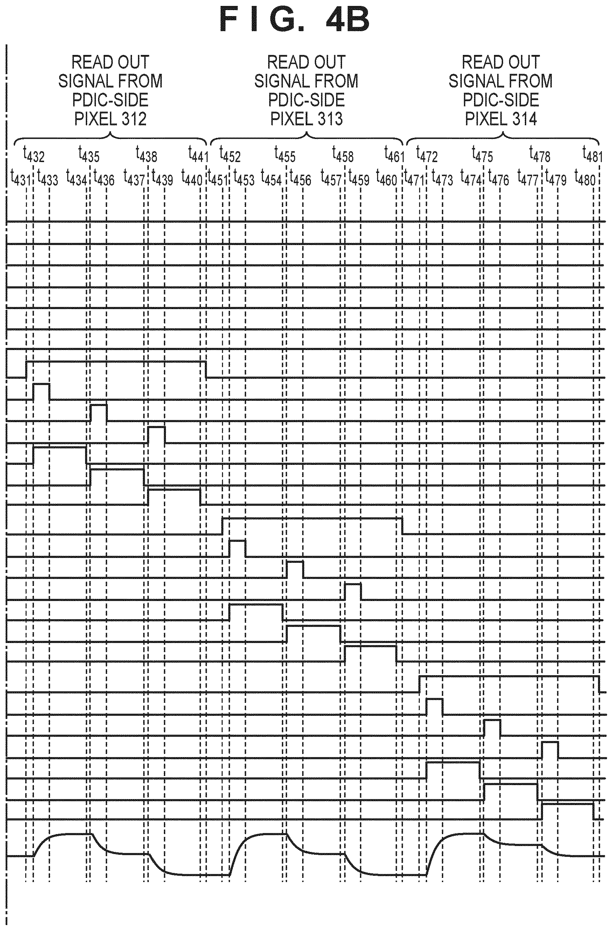

FIGS. 4A and 4B illustrate a timing chart of the reset operation of the PDA 331 and PDB 332, the accumulation period, and the signal readout timing from the PDIC-side pixels to the MEMIC-side pixels. In this specification, each timing is shown as $(t_{401})$. In FIG. 4A, $\phi$SEL indicates ON/OFF of the control signal applied to the SEL 337, with the upper side indicating ON and the lower side indicating OFF. For other control signals, similarly, $\phi$ is attached before each component to which the control signal is applied. In addition, in order to distinguish the control signals applied to the PDIC-side pixels 311 to 314 and the MEMIC-side pixels 321 to 324, "1" is attached to the control signals applied to the pixel 105 consisting of the PDIC-side pixel 311 and the MEMIC-side pixel 321. Similarly, "2" is attached to the control signals applied to the pixel 105 consisting of the PDIC-side pixel 312 and the MEMIC-side pixel 322, and "3" is attached to the control signals applied to the pixel 105 consisting of the PDIC-side pixel 313 and the MEMIC-side pixel 323, and "4" is attached to the control signal applied to the pixel 105 consisting of the PDIC-side pixel 314 and the MEMIC-side pixel 324. $V_{HB}$ indicates how the voltage of the HB 205 changes.

The reset operation of the PDA 331 and PDB 332 is performed by sequentially resetting the PDIC-side pixel 311 $(t_{401} \sim t_{402})$, PDIC-side pixel 312 $(t_{403} \sim t_{404})$, PDIC-side pixel 313 $(t_{405}$ to $t_{406})$, PDIC-side pixel 314 $(t_{407}$ to $t_{408})$ so that the time difference between the PDIC-side pixel 311, PDIC-side pixel 312, PDIC-side pixel 313, and PDIC-side pixel 312 in the reset operaiton is the same as that in the signal read operation from the PDIC 201 side to the MEMIC 202 side, which will be described later. In the reset operation of each PDIC-side pixel, the RES 336, TXA 333, and TXB 334 are turned on/off at the same time to discharge charges in the PDA 331 and PDB 332.

The period from the completion of the reset operation of the PDA 331 and PDB 332 to the start of the readout operation from the PDIC-side pixels to the MEMIC-side pixels is the exposure period.

The signal readout period from the PDIC-side pixels to the MEMIC-side pixels is comprised of a signal readout period of the PDIC-side pixel 311 (t411 to t421), a signal readout period of the PDIC-side pixel 312 (t431 to t441), a signal readout period of the PDIC-side pixel 313 (t451 to t461) and a signal readout period of the PDIC-side pixel 314 (t471 to t481), which are successively performed. Since the signal readout operation from each PDIC-side pixel is the same, the operation during the signal readout period of the PDIC-side pixel 311 will be described below.

First, the SEL 337 is turned on $(t_{411})$, the SF 338 and CS 361 are connected to operate the SF 338 as a source follower, so that the node of the HB 205 becomes a voltage corresponding to the voltage of the FD 335. Subsequently, the RES 336 and GSN 344 are turned on to reset the FD 335, and the MEMN 341 and HB 205 are connected $(t_{412})$. After that, the RES 336 is turned off $(t_{413})$, and the GSN 344 is turned off $(t_{414})$ after the potential of the MEMN 341 is settled. Thereby, the MEMN 341 holds a voltage (FD reset voltage) corresponding to the voltage of the FD 335 before the charges accumulated in the PDA 331 and PDB 332 are transferred.

Subsequently, the TXA 333 and GSA 345 are turned on, and when the charge accumulated in the PDA 331 during the accumulation period is transferred to the FD 335 $(t_{415})$, the voltage across the FD 335 drops by an amount corresponding to the transferred charge. After that, the TXA 333 is turned off $(t_{416})$, and the GSA 345 is turned off $(t_{417})$ after the potential of the MEMA 342 is settled. As a result, the MEMA 342 holds a voltage lower than the reset voltage of the FD 335 by the amount corresponding to the charge accumulated in the PDA 331 during the accumulation period.

Subsequently, the TXB 334 and GSB 346 are turned on, and when the charge accumulated in the PDB 332 during the accumulation period is transferred to the FD 335 $(t_{418})$, the voltage across the FD 335 drops by an amount corresponding to the transferred charge. After that, the TXB 334 is turned off $(t_{419})$, and the GSB 346 is turned off $(t_{420})$ after the potential of the MEMB 343 is settled. As a result, the MEMB 343 holds a voltage lower than the reset voltage of the FD 335 by the amount corresponding to the charge accumulated in the PDA 331 and PDB 332 during the accumulation period.

After that, by turning off the SEL 337 $(t_{421})$, the readout operation of the PDIC-side pixel 311 is completed.

• Signal Readout Operation from MEMIC-Side Pixels to Column Circuit

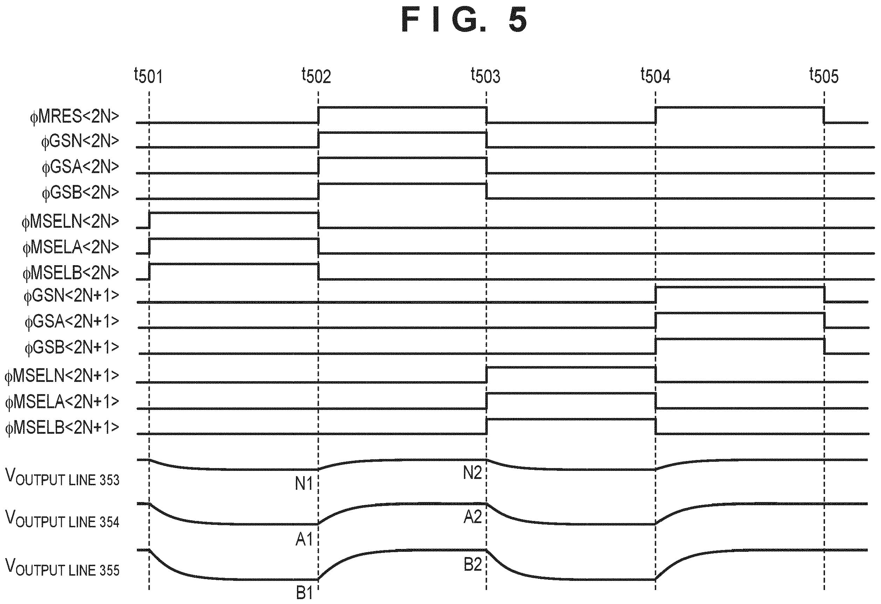

Signal readout from the MEMIC-side pixels is performed sequentially in units of one row. FIG. 5 is a timing chart of the readout operation for the 2Nth row and the readout operation for the 2N+1th row. Note that N is an integer of 0 or more. $\phi$MSELN<2N> indicates ON/OFF of the MSELs of the pixels in the 2Nth row. During the readout operation of the MEMIC-side pixels, the constant current source CS 361 for PDIC readout is turned off. Also, since the read operation of the 2Nth row and the readout operation of the 2N+1 row are substantially the same, the readout operation of the 2Nth row will be described.

First, the MSELN 350, MSELA 351 and MSELB 352 are turned on $(t_{501})$. The output signal lines 353, 354, 355 are connected to column constant current sources (not shown). Therefore, the MSFN 347, MSFA 348, and MSFB 349 operate as source followers, and the output signal lines 353, 354, and 355 become to have voltages corresponding to the voltages of the MEMN 341, MEMA 342, and MEMB 343, respectively. After the output signal lines 353, 354 and 355 are settled, the voltages of the output signal lines 353, 354 and 355 are respectively AD-converted by the column circuit 103. The signal corresponding to the voltage of the output signal line 353 at this time is expressed as N1, the signal corresponding to the voltage of the output signal line 354 is expressed as A1, and the signal corresponding to the voltage of the output signal line 355 is expressed as B1.

After AD conversion is completed, the MSELN 350, MSELA351 and MSELB 352 are turned off and the MRES 362, GSN 344, GSA 345 and GSB 346 are turned on to reset the MEMN 341, MEMA 342 and MEMB 343 ($t_{502}$). Then, after the output signal lines 353, 354, and 355 are settled to voltages corresponding to the respective reset levels of the MEMN 341, MEMA 342, and MEMB 343, the voltages of the output signal lines 353, 354, and 355 are AD-converted by the column circuit 103. The signal corresponding to the voltage of the output signal line 353 at this time is expressed as N2, the signal corresponding to the voltage of the output signal line 354 is expressed as A2, and the signal corresponding to the voltage of the output signal line 355 is expressed as B2. From the signals obtained in this way, by calculating

$$(A1 - A2) - (N1 - N2)$$

it is possible to obtain the amount of charge accumulated in the PDA 331 during the accumulation period. Further, by calculating

$$(B1 - B2) - (A1 - A2)$$

it is possible to obtain the amount of charge accumulated in the PDB 332 during the accumulation period.

The reason for subtracting the voltages corresponding to the reset levels of the MEMN 341, MEMA 342, and MEMB 343 as shown by (N1-N2), (A1-A2), and (B1-B2) is to cancel variations in the threshold values of the the MSFN 347, MSFA 348 and MSFB 349 and to cancel the voltage drop corresponding to the length of the output signal line from the pixel to the column circuit. In addition, by holding the signals corresponding to N2, A2, and B2 as adjustment values for one frame outside the image sensor 100, $t_{502}$ to $t_{503}$ can be omitted. Further, in the present embodiment, for signal readout of one pixel, AD conversion is performed twice for each of the output signal lines 353, 354, and 355. However, the difference between the voltage immediately before $t_{502}$ and the voltage immediately before $t_{503}$ may be AD-converted.

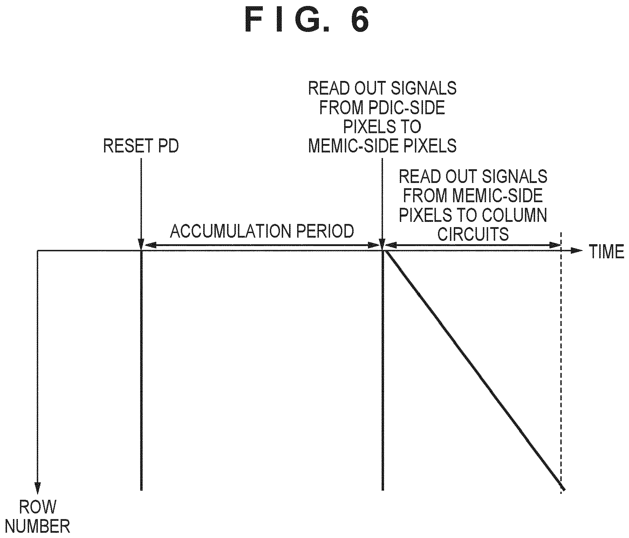

FIG. 6 is a timing chart showing the row numbers of pixels and the schematic timing of each operation. The PD reset operation, the accumulation period, and the readout of signals from the PDIC-side pixels to the MEMIC-side pixels are sequentially performed in units of four pixels in all rows, and the readout of signals from the MEMIC-side pixels to the column circuits is sequentially performed in units of one row. Therefore, although the timings of the accumulation periods are different among the four pixels, the timings of the accumulation periods of the pixel array portion 101 as a whole are almost the same, resulting in an operation close to that of a global shutter.

As described above with reference to FIG. 2, by arranging the HB 205 for each pixel, it is possible to perform a global shutter operation in which the timing of the accumulation period is the same over all rows.

[Structure of Light Receiving Portion]

• Basic Structure of Light Receiving Portion

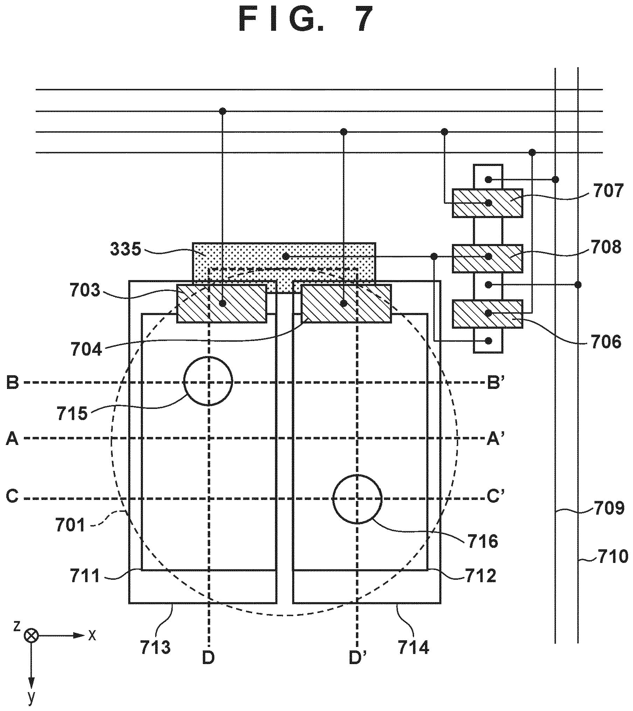

Next, the basic configuration of the PDIC-side pixels in this embodiment will be described with reference to FIGS. 7 to 10.

FIG. 7 is a schematic diagram showing a basic layout of elements constituting the PDIC-side pixel according to this embodiment. In FIG. 7, the horizontal direction of the drawing is the x direction, the vertical direction of the drawing is the y direction, and the direction protruding from the drawing is the z direction. Further, in the present embodiment, "plan view" refers to a view seen from the z direction or -z direction with respect to a plane (x-y plane) substantially parallel to the surface of the semiconductor substrate on which the gates of the transistors are arranged. Also, in this embodiment, the "horizontal" direction refers to the x direction, the "vertical" direction refers to the y direction, and the "depth" direction refers to the z direction.

In FIG. 7, reference numeral 701 indicates a microlens (ML); 703, a gate electrode of the TXA 333; 704, a gate electrode of the TXB 334; 706, a gate electrode of the RES 336; 707, a gate electrode of the SEL 337; 708, a gate of the SF 338; 709, a signal transfer line; and 710, a voltage supply line. The same reference numerals are assigned to the same configurations as in FIG. 3, and detailed description thereof will be omitted.

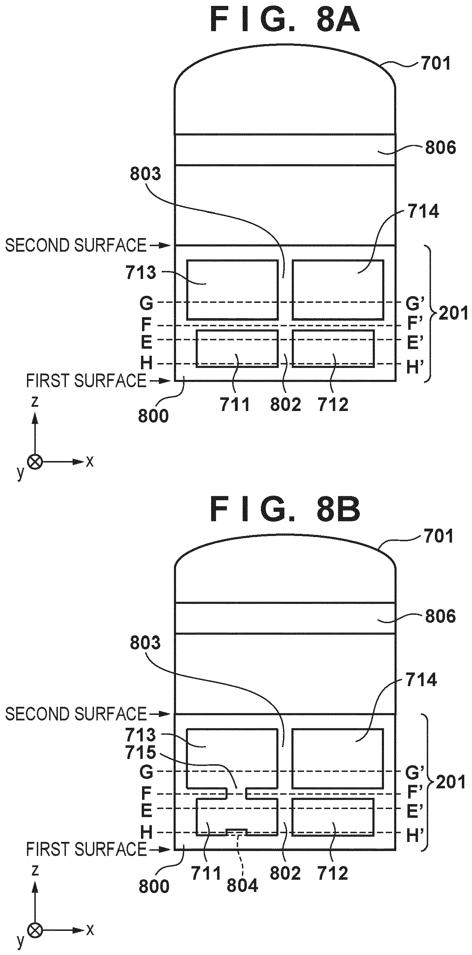

The PDA 331 includes a storage region 711, a sensitivity region 713, and an N-type connection region 715, and the PDB 332 includes a storage region 712, a sensitivity region 714, and an N-type connection region 716. These storage regions 711 and 712, sensitive regions 713 and 714, and N-type connection regions 715 and 716 are made of N-type semiconductors. The sensitive regions 713 and 714 are larger in area than the storage regions 711 and 712. Further, as will be described in detail below with reference to FIGS. 8A to 8C, the storage regions 711 and 712 are formed at a first depth and the sensitivity regions 713 and 714 are formed at a second depth different from the first depth. In order to make the explanation easier to understand, a region where charges are mainly generated in response to incident light is called a "sensitivity region", and a region where the generated charges are mainly accumulated is called an "storage region". However, there is no clear division between the charge generation region and the charge storage region. Charges are also generated in the storage regions 711 and 712 according to the light that reaches there, and some of the generated charges remain in the sensitivity regions 713 and 714.

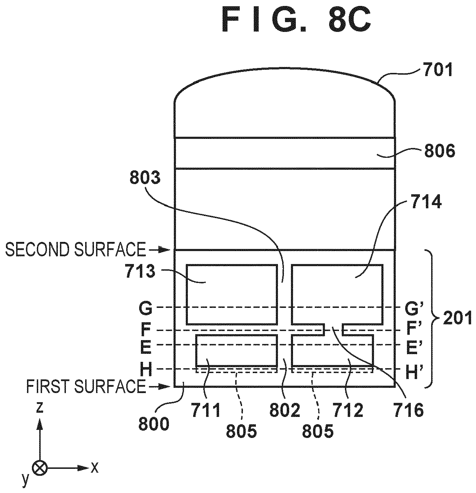

FIGS. 8A to 8C are diagrams schematically showing the basic cross-sectional structure of the PDIC-side pixel. FIG. 8A is a cross sectional schematic diagram taken along an A-A' line of FIG. 7, FIG. 8B is a cross sectional schematic diagram taken along a B-B' line of FIG. 7, and FIG. 8C is a cross sectional schematic diagram taken along a C-C' line of FIG. 7. The PDIC 201 has a first surface and a second surface opposite the first surface. The first surface is the front surface of the PDIC 201 and the second surface is the back surface of the PDIC 201. The direction from the first surface to the second surface is the positive direction of the Z direction. On the first surface (front surface) side of the PDIC 201, gate electrodes of transistors, a multilayer wiring structure, and the like are arranged. In addition, on the second surface (back surface) side of the PDIC 201, an optical structure such as a color filter 806 and the ML701 that collectively cover the two photodiodes of each pixel is arranged, and light enters from the second surface (back surface) side.

As shown in FIG. 8A, the PDIC 201 includes a P-type semiconductor region 800, the storage regions 711 and 712 and the sensitivity regions 713 and 714 surrounded by the P-type semiconductor region 800. The storage region 711 and sensitivity region 713 have different shapes in plan view, and so as the storage region 712 and sensitivity region 714, and partially overlap each other in plan view. Further, as described above, the storage regions 711 and 712 and the sensitivity regions 713 and 714 are arranged at different positions in the depth direction, and the storage regions 711 and 712 are located in the depth closer to the first surface side (first depth), and the sensitivity regions 713 and 714 are located in the depth closer to the second surface side (second depth). In the P-type semiconductor region 800, a storage isolation region 802 separates the storage regions 711 and 712, and a sensitivity isolation region 803 separates the sensitivity regions 713 and 714.

As shown in FIG. 8B, the storage region 711 and the sensitivity region 713 are connected in the depth direction via the N-type connection region 715. Further, as shown in FIG. 8C, the storage region 712 and the sensitivity region 714 are connected in depth direction via an N-type connection region 716.

In FIG. 8B, a region 804 is recessed in the Z direction by the P-type semiconductor in the storage region 711. This recessed region 804 suppresses charge being accumulated in an area, that overlaps with the N-type connection region 715 in plan view, on the first surface side of the storage region 711. As a result, when the signal charge accumulated in the storage region 711 of the PDA 331 is transferred to the FD 335, an amount of signal charge left in the storage region 711 after the transfer operation is suppressed. It should be noted that other methods such as lowering the impurity concentration of a portion of the storage region 711 may be used instead of the recessed region 804 as long as an amount of signal charge left in the storage region 711 can be suppressed.

Also, as shown in FIG. 8C, the lengths in the Z-direction of the storage regions 711 and 712 are shorter than the lengths in the Z-direction of the storage regions 711 and 712 in the cross sections shown in FIGS. 8A and 8B, and a portion 805 by which the lengths of the storage regions 711 and 712 are shortened is formed of a P-type semiconductor. As a result, when the signal charge accumulated in the storage regions 711 and 712 are transferred to the FD 335, an amount of signal charge left in the storage regions 711 and 712 is suppressed.

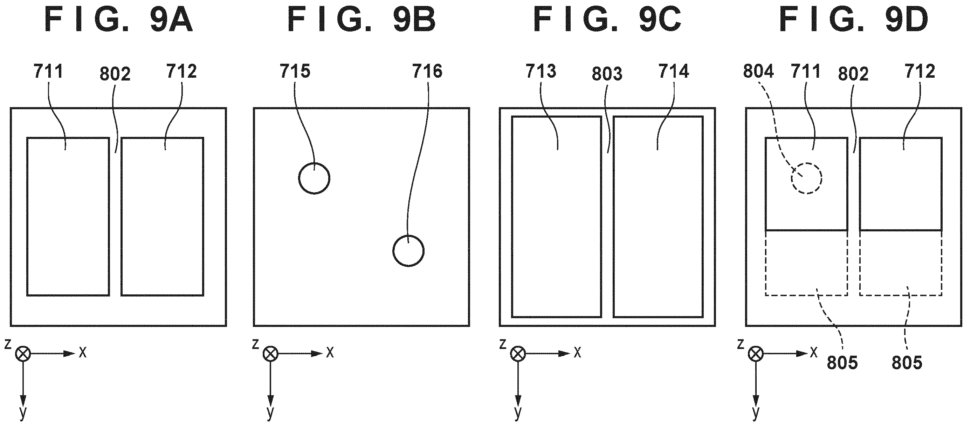

FIGS. 9A-9D are diagrams schematically showing x-y cross sections of the PDA 331 and PDB 332 in different depths in the z direction. FIG. 9A is a cross-sectional diagram taken along an E-E' line of FIGS. 8A to 8C, FIG. 9B is a cross-sectional diagram taken along an F-F' line of FIGS. 8A to 8C, FIG. 9C is a cross-sectional diagram taken along a G-G' line of FIGS. 8A to 8C, and FIG. 9D is a cross-sectional diagram taken along an H-H' line of FIGS. 8A to 8C. As shown in FIG. 9D, in the partial regions of the storage regions 711 and 712 located away from the gate electrodes 703 and 704, as described with reference to FIG. 8C, the storage regions 711 and 712 are replaced by cutout areas 805 made of P-type semiconductor.

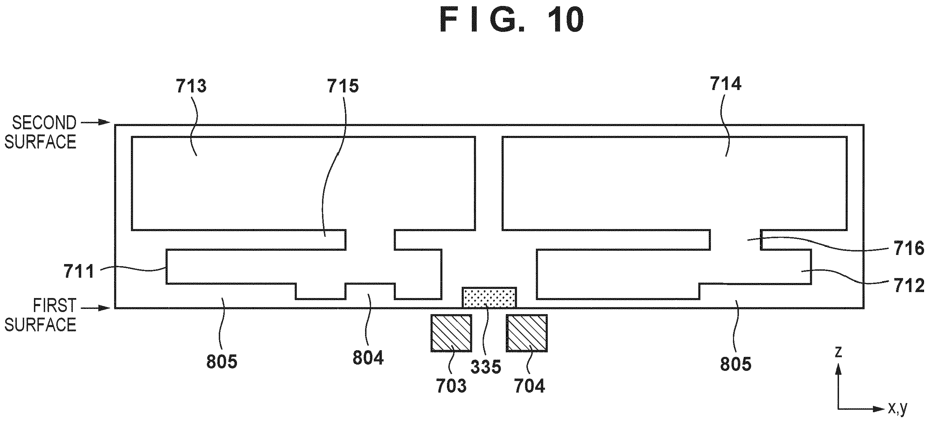

FIG. 10 is a diagram schematically showing a cross section taken along a D-D' line of FIG. 7. The storage regions 711 and 712, the sensitivity regions 713 and 714, and the N-type connection regions 715 and 716 are shown in the same drawing along the D-D' polygonal line of FIG. 7 on the x-y plane. During the accumulation period, when light is incident on the second surface of the semiconductor substrate 801 through the ML 701, electrons (signal charge) are generated mainly in the sensitivity regions 713 and 714 by photoelectric conversion. Most of the signal charge generated in the sensitivity region 713 moves to the storage region 711 through the N-type connection region 715 and is accumulated there. Also, most of the signal charge generated in the sensitivity region 714 moves to the storage region 712 through the N-type connection region 716 and is accumulated there. In order to realize signal charge transfer from the sensitivity region to the storage region, it is desirable that the potential that affects electrons monotonously decrease on the charge transfer path from the sensitivity region to the storage region.

• Horizontal Division Layout and Vertical Division Layout

Since the storage regions and the sensitivity regions are arranged at different depths, the layout direction of the sensitivity regions 713 and 714 of the PDA 331 can be made different from that of the PDB 332 while keeping the positions of the readout transistors of the PDIC-side pixel. The layout directions of the sensitivity regions of the PDA 331 and PDB 332 may be differed with the positions of the readout transistors of the PDIC-side pixel being changed.

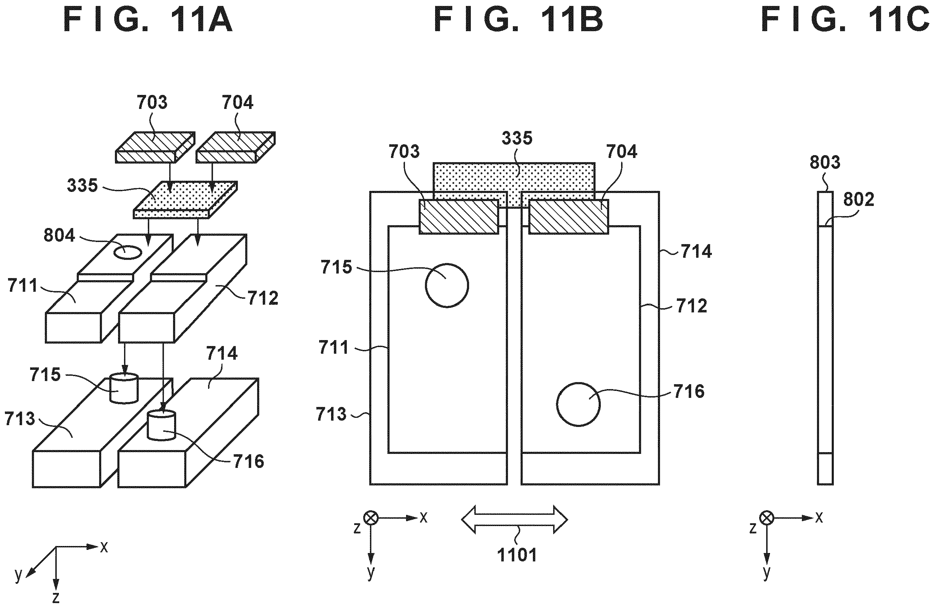

FIGS. 11A to 11C show the layout of the PDIC-side pixels 311, 312, 314, in which the sensitivity regions 713, 714 are horizontally divided (referred to as "horizontal division layout", hereinafter).

FIG. 11A is an exploded perspective view of the storage regions 711 and 712, sensitivity regions 713 and 714, N-type connection regions 715 and 716, gate electrode 703 of the TXA 333, gate electrode 704 of the TXB 334, and FD 335 of the pixel 105 having the horizontal division layout. In the horizontal division layout, the storage regions 711 and 712 and the sensitivity regions 713 and 714 all extend in the y-direction, i.e., the same direction.

FIG. 11B is a schematic plan view showing the positional relationship between the storage regions 711 and 712, sensitivity regions 713 and 714, N-type connection regions 715 and 716, gate electrode 703 of the TXA 333, gate electrode 704 of the TXB 334, and FD 335 of the pixel 105 having the horizontal division layout in a plan view. In the horizontal division layout, since the sensitivity regions 713 and 714 in which charge is generated by photoelectric conversion are arranged in the x direction, it is possible to obtain phase difference signals in which the pupil division direction is the x direction. Reference numeral 1101 indicates the division direction of the phase difference signals.

FIG. 11C is a schematic plan view showing the positional relationship between the storage isolation region 802 and the sensitivity isolation region 803 in the pixel 105 having the horizontal division layout. In the horizontal division layout, both the storage isolation region 802 and the sensitivity isolation region 803 extend in the y-direction.

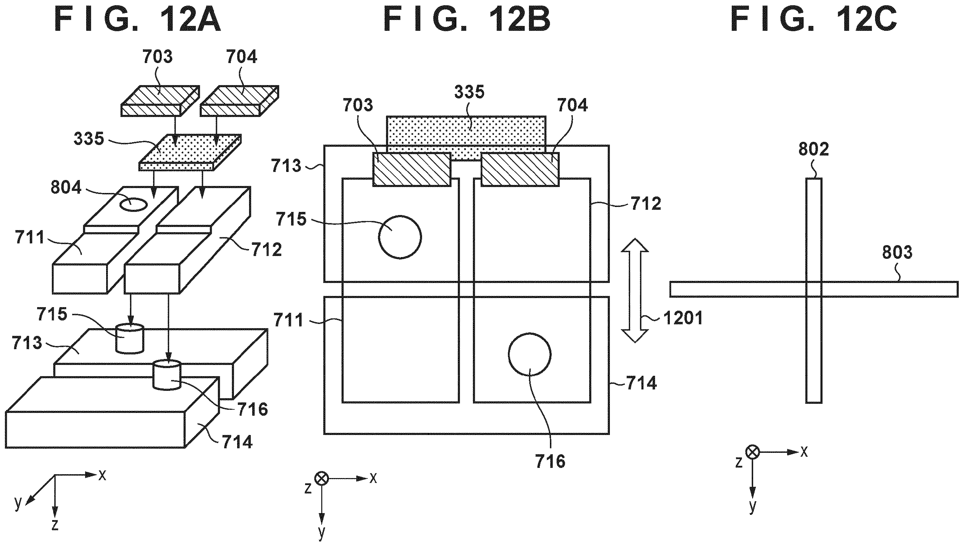

FIGS. 12A to 12C show the layout of the PDIC-side pixel 313, in which the sensitivity regions 713 and 714 are divided in the vertical direction (referred to as "vertical division layout", hereinafter).

FIG. 12A is an exploded perspective view of the storage regions 711 and 712, sensitivity regions 713 and 714, N-type connection regions 715 and 716, gate electrode 703 of the TXA 333, gate electrode 704 of the TXB 334, and FD 335 of the pixel 105 having the vertical division layout. In the vertical division layout, the storage regions 711 and 712 extend in the y-direction and the sensitivity regions 713 and 714 extend in the x-direction, which are orthogonal in plan view, i.e., in different directions.

FIG. 12B is a schematic plan view showing the positional relationship between the storage regions 711 and 712, sensitivity regions 713 and 714, N-type connection regions 715 and 716, gate electrode 703 of the TXA 333, gate electrode 704 of the TXB 334, and FD 335 of the pixel 105 having the vertical division layout in plan view. In the vertical division layout, since the sensitivity regions 713 and 714 in which charge is generated by photoelectric conversion are arranged in the y direction, it is possible to obtain phase difference signals in which the pupil division direction is the y direction. Reference numeral 1201 indicates the division direction of the phase difference signals.

FIG. 12C is a schematic plan view showing the positional relationship between the storage isolation region 802 and the sensitivity isolation region 803 in the pixel 105 having the vertical division layout. In the vertical division layout, the storage isolation region 802 extends in the y direction and the sensitivity isolation region 803 extends in the x direction.

[Arrangement of Horizontally Divided Pixels, Vertically Divided Pixels, and Color Filters]

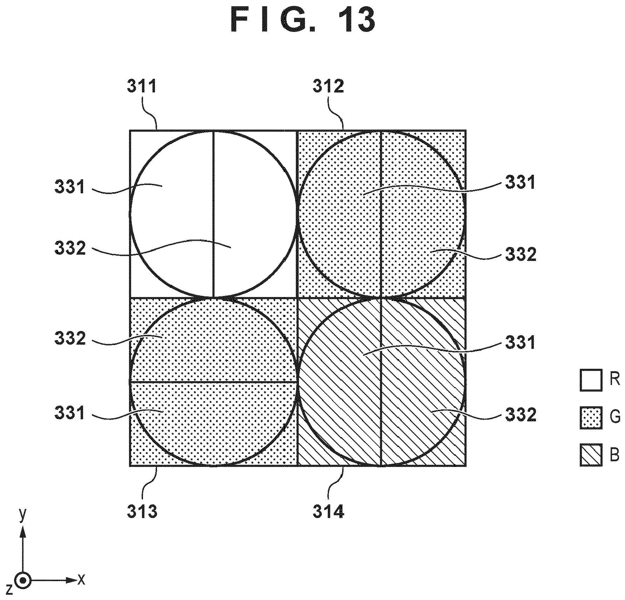

FIG. 13 is a diagram schematically showing an arrangement of the PDIC-side pixels 311, 312, and 314 having the horizontal division layout (referred to as "horizontally divided pixels", hereinafter) and the PDIC-side pixel 313 having the vertical division layout (referred to as "vertically divided pixels", hereinafter) and the arrangement of the color filter 806 in this embodiment in a range of 2×2 pixels.

The horizontally divided pixel 311 with a color filter 806 having R (red) spectral sensitivity is arranged on the upper left, the horizontally divided pixel 312 with the color filter 806 having G (green) spectral sensitivity is arranged on the upper right, the vertically divided pixel 313 with the color filter 806 having G (green) spectral sensitivity is arranged on the lower left, and the horizontally divided pixel 314 with the color filter 806 having B (blue) spectral sensitivity is arranged on the lower right, and thus the arrangement of the color filters 806 is Bayer arrangement.

The arrangement of 2×2 pixels shown in FIG. 13 is extended over the entire pixel array portion 101, thereby the phase difference signals with the pupil division direction in the horizontal direction and the phase difference signals with the pupil division direction in the vertical direction can be obtained in the entire area of the pixel array portion 101.

Further, since horizontal phase difference signals are obtained for each of the pixels with R, G, and B color filters, horizontal phase difference signals can be obtained regardless of the color of the object. In addition, the phase difference signals in the vertical direction are obtained from the pixels with a G color filter, which has the highest transmittance among R, G, and B color filters, so the accuracy of the obtained phase difference signals is higher comparing to a case where the phase difference signals are obtained from the pixels with an R color filter or a B color filter.

[Structure of MEMIC-Side Pixel]

Next, the structure of the MEMIC-side pixel will be described.

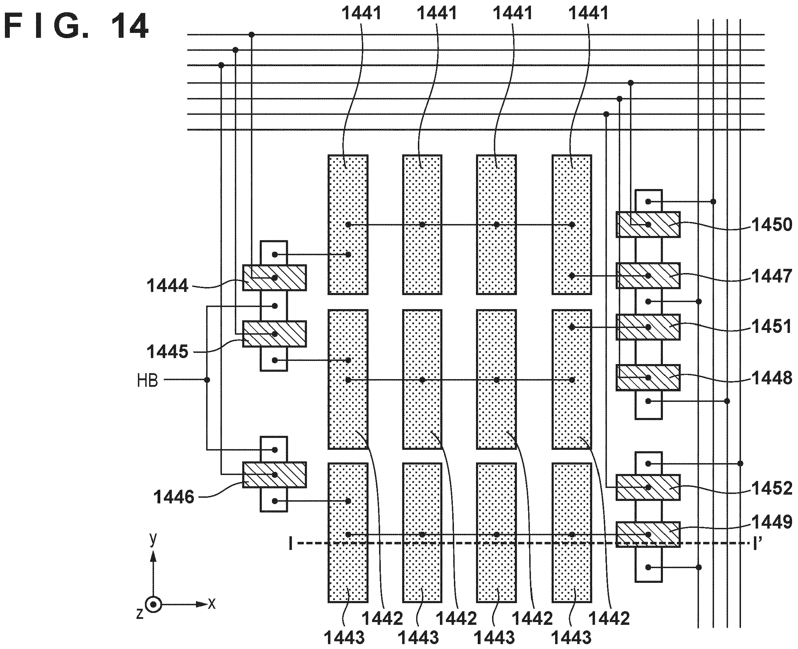

FIG. 14 is a diagram schematically showing the basic layout of the elements forming the MEMIC-side pixel 321 according to this embodiment. In FIG. 14, reference numeral 1444 indicates a gate electrode of the GSN 344; 1445, a gate electrode of the GSA 345; 1446, a gate electrode of the GSB 346; 1447, a gate electrode of the MSFN 347; 1451, a gate electrode of the MSFA348, 1449, a gate electrode of the MSFB 349; 1450, a gate electrode of the MSELN 350; 1448, a gate electrode of the MSELA 351; 1452, a gate electrode of the MSELB 352; 1441, a gate electrode of the MEMN 341; 1442, a gate electrode of the MEMA 342; and 1443, a gate electrode of the MEMB 343. In this embodiment, the signal holding capacitors MEMN 341, MEMA 342 and MEMB 343 are trench MOS type.

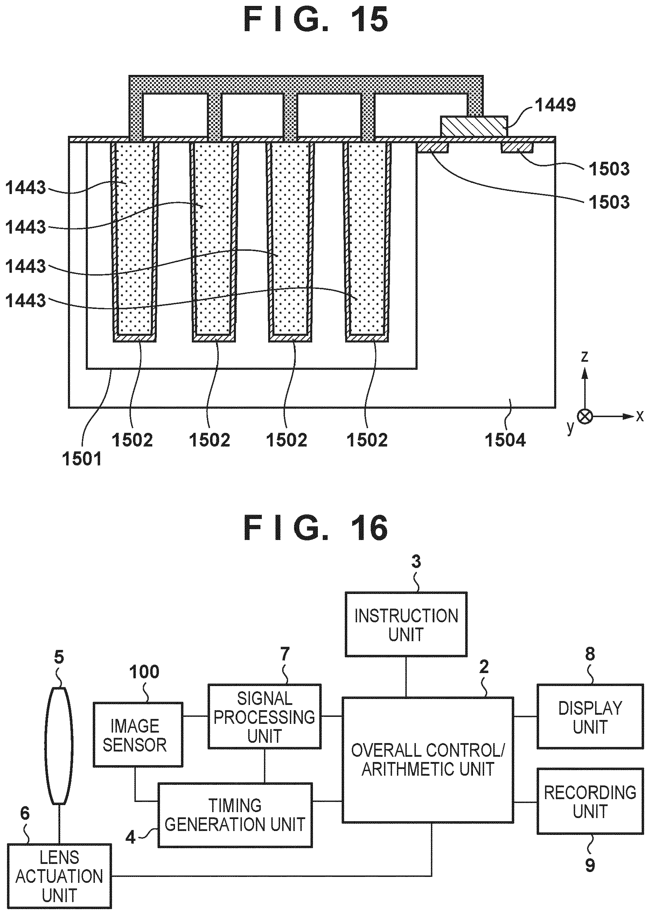

FIG. 15 is a cross sectional schematic diagram taken along an I-I' line of FIG. 14. Within a P-type region 1504 is an N-type region 1501, and within the N-type region 1501 are gate electrodes 1443 of the MEMB 343. Further, an insulating film layer 1502 is arranged between the gate electrodes 1443 and the N-type region 1501, and capacitances (MEMB 343) are formed between the gate electrodes 1443 and the N-type region 1501 through this insulating film. Since the capacitances can be formed in the depth direction in this way, the capacitance per unit area in the X-Y plane can be made larger than that of a normal MOS capacitance. Gate electrodes other than the signal holding capacitors have a planar MOSFET structure and are arranged so as to control the potential of the Si surface separated by an STI 1503.

[Overall Configuration]

FIG. 16 is a block diagram showing a schematic configuration of an image capturing apparatus according to the embodiment of the present invention. The image capturing apparatus of the present embodiment includes an image sensor 100 having the configuration as described above, an overall control/arithmetic unit 2, an instruction unit 3, a timing generation unit 4, an imaging lens unit 5, a lens actuation unit 6, a signal processing unit 7, a display unit 8 and a recording unit 9.

The imaging lens unit 5 forms an optical image of a subject on the image sensor 100. Although it is represented by one lens in the figure, the imaging lens unit 5 may include a plurality of lenses including a focus lens, a zoom lens, and so on, and a diaphragm, and may be detachable from the main body of the image capturing apparatus or may be integrally configured with the main body.

The image sensor 100 has the configuration as described in the above embodiment, converts the light incident through the imaging lens unit 5 into electric signals and outputs them. Signals are read out from each pixel of the image sensor 100 so that pupil division signals that can be used in phase difference focus detection and an image signal that is a signal of each pixel can be acquired.

The signal processing unit 7 performs predetermined signal processing such as correction processing on the signals output from the image sensor 100, and outputs the pupil division signals used for focus detection and the image signal used for recording.

The overall control/arithmetic unit 2 comprehensively actuates and controls the entire image capturing apparatus. In addition, the overall control/arithmetic unit 2 also performs calculations for focus detection using the pupil division signals processed by signal processing unit 7, and performs arithmetic processing for exposure control, and predetermined signal processing, such as development for generating images for recording/playback and compression, on the image signal.

The lens actuation unit 6 actuates the imaging lens unit 5, and performs focus control, zoom control, aperture control, and the like on the imaging lens unit 5 according to control signals from the overall control/arithmetic unit 2.

The instruction unit 3 receives inputs such as shooting execution instructions, actuation mode settings for the image capturing apparatus, and other various settings and selections that are input from outside by the operation of the user, for example, and sends them to the overall control/arithmetic unit 2.

The timing generation unit 4 generates a timing signal for actuating the image sensor 100 and the signal processing unit 7 according to a control signal from the overall control/arithmetic unit 2.

The display unit 8 displays a preview image, a playback image, and information such as the actuation mode settings of the image capturing apparatus.

The recording unit 9 is provided with a recording medium (not shown), and records an image signal for recording. Examples of the recording medium include semiconductor memories such as flash memory. The recording medium may be detachable from the recording unit 9 or may be built-in.

[Calculation of Defocus Amount]

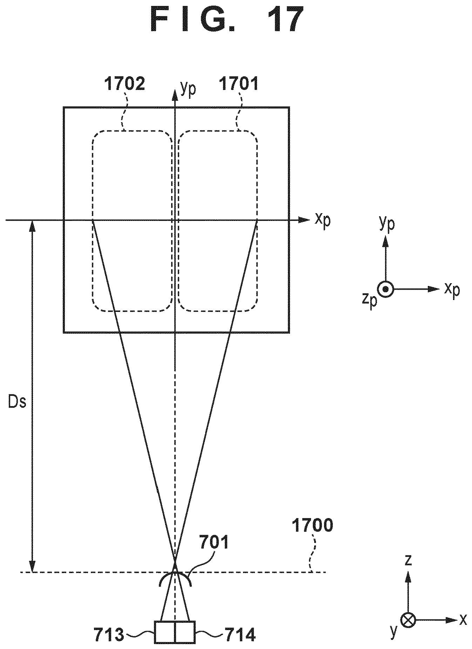

Next, a calculation method for calculating a defocus amount from the pupil division signals in the overall control/arithmetic unit 2 will be described with reference to FIGS. 17 to 20. Since the calculation method for calculating the defocus amount from the horizontal phase difference signals and the calculation method for calculating the defocus amount from the vertical phase difference signals are the same in principle, a calculation method for calculating the defocus amount from the horizontal phase difference signals will be explained.

FIG. 17 is a horizontal cross-sectional view of the horizontally divided pixels 311, 312 and 314 whose pupil division direction is horizontal and a pupil plane at the position separated from an imaging plane 1700 of the image sensor 100 by a distance Ds in the negative direction of the z-axis. In FIG. 17, x, y, and z indicate the coordinate axes on the imaging plane 1700, and $x_p$, $y_p$, and $z_p$ indicate the coordinate axes on the pupil plane.

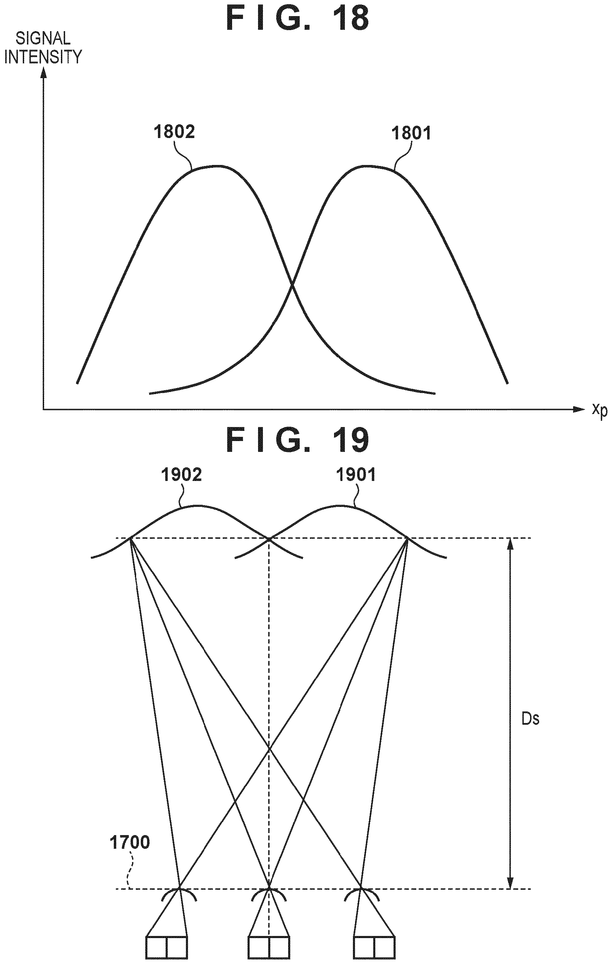

The pupil plane and the light receiving surface (second surface) of the image sensor 100 have substantially conjugated relationship via the ML 701. Therefore, the luminous flux that has passed through a partial pupil region 1701 is mostly received in the sensitivity region 713 (PDA). Further, the luminous flux that has passed through a partial pupil region 1702 is mostly received in the sensitivity region 714 (PDB). Signal charges photoelectrically converted near the boundary between the sensitivity regions 713 and 714 are stochastically transported to the storage region 711 or the storage region 712. Accordingly, at the boundary between the partial pupil region 1701 and the partial pupil region 1702, the signal gradually switches as the x coordinate increases, and the x-direction dependency of the pupil intensity distribution has a shape as illustrated in FIG. 18. Here, the pupil intensity distribution corresponding to the PDA 331 is referred to as a first pupil intensity distribution 1801, and the pupil intensity distribution corresponding to the PDB 332 is referred to as a second pupil intensity distribution 1802.

Next, with reference to FIG. 19, a sensor entrance pupil of the image sensor 100 will be described. In the image sensor 100 of the present embodiment, the MLs 701 of respective pixels 105 are continuously shifted toward the center of the image sensor 100 depending on the image height coordinates of the pixels on the two-dimensional plane. That is, each ML 701 is arranged so as to be more eccentric toward the center as the image height of the pixel 105 becomes higher. The center of the image sensor 100 and the optical axis of the imaging optical system are shifted by the mechanism that reduces the influence of blurring due to camera shake or the like by moving the imaging optical system or the image sensor 100, but they are substantially the same. As a result, in the pupil plane located at a distance Ds from the image sensor 100, the first pupil intensity distribution 1801 and the second pupil intensity distribution 1802 of horizontally divided pixels arranged at different image height of the image sensor 100 substantially match.

Hereinafter, the first pupil intensity distribution 1801 and the second pupil intensity distribution 1802 are called the "sensor entrance pupil" of the image sensor 100, and the distance Ds is called the "sensor pupil distance" of the image sensor 100. It should be noted that it is not necessary to configure all pixels to have a single entrance pupil distance. For example, the pixels located at up to 80% of image height may have substantially the same entrance pupil distance, or the pixels in different rows or in different detection areas may be configured to have different entrance pupil distances.

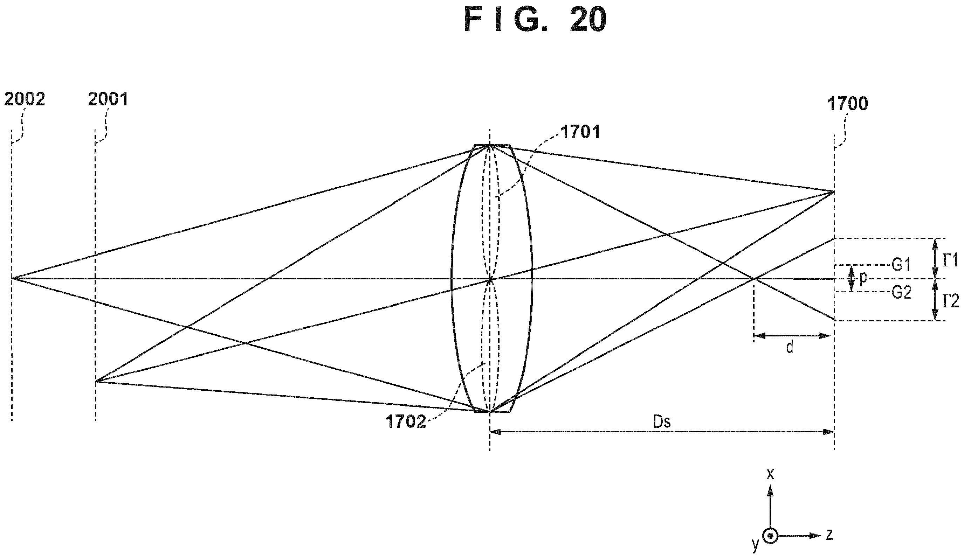

FIG. 20 shows a schematic relationship diagram between an image shift amount and a defocus amount between parallax images. The image sensor 100 (not shown) of the present embodiment is aligned on the imaging plane 1700, and the exit pupil of the imaging optical system is divided into the partial pupil region 1701 and the partial pupil region 1702 as in FIG. 17.

For a defocus amount d, the magnitude of the distance from the imaging position of the subject to the imaging plane is given by | d |, the front focused state in which the in-focus position of the subject is on the subject side with respect to the imaging plane is expressed by negative (d < 0), and the rear focused state in which the in-focus position of the subject is on the opposite side of the subject with respect to the imaging plane is expressed by positive (d > 0). The in-focus state in which the in-focus position of the subject is on the imaging plane is expressed as d = 0. FIG. 20 shows an example in which a subject on an object plane 2001 is in the in-focus state (d = 0) and a subject on an object plane 902 is in the front focused state (d < 0). The front focused state (d < 0) and the rear focused state (d > 0) are both referred to as a defocus state (| d | > 0).

In the front focused state (d < 0), among the luminous fluxes from the subject on the object plane 2002, the luminous flux that has passed through the partial pupil region 1701 converges once and then diverges to have the radius Γ1 (Γ2) about the position G1 (G2) as the center of gravity of the luminous flux, and formed as a blurred image on the imaging plane 1700. The blurred image is received by the sensitivity region 713 (PDA 331) and the sensitivity region 714 (PDB 332), and parallax images are generated. Therefore, the generated parallax images are of a blurred image of the subject with the image of the subject on the object plane 2002 being spread to have the radius Γ1 (Γ2) about the position G1 (G2) of the center of gravity.

The radius Γ1 (Γ2) of blur of the subject image generally increases proportionally as the magnitude | d | of the defocus amount d increases. Similarly, the magnitude | p | of an image shift amount p (= G2-G1) between the subject images of the parallax images also increases approximately proportionally as the magnitude | d | of the defocus amount d increases. The same relationship holds in the rear focused state (d> 0), although the image shift direction of the subject images between the parallax images is opposite to that in the front focused state. In the in-focus state (d = 0), the positions of the centers of gravity of the subject images in the parallax images are the same (p = 0), and no image shift occurs.

Therefore, with regard to the two phase difference signals obtained by using the signals from the sensitivity region 713 (PDA 331) and the sensitivity region 714 (PDB 332), as the magnitude of the defocus amount of the parallax images increases, the magnitude of the image shift amount between the two phase difference signals in the x direction increases. Based on this relationship, the phase difference focus detection is performed by converting the image shift amount calculated by performing correlation operation on the image shift amount between the parallax images in the x-direction into the defocus amount.

[Vertically Divided Pixels and Horizontally Divided Pixels in Calculating Defocus Amount]

In the calculation of the defocus amount described above, it is necessary to calculate an image shift amount. To calculate the image shift amount, two phase difference signals (signal obtained from the PDA 331 and signal obtained from PDB 332) should be compared. Therefore, in order to calculate the image shift amount in the vertical direction, it is necessary to compare two phase difference signals obtained from different rows. Therefore, in an image sensor that does not have a global shutter function, different rows have phase difference signals corresponding to charges accumulated during accumulation periods at different timings, and there is a possibility that the accuracy of the phase difference detection in the vertical direction may be lower than that of the phase difference detection in the horizontal direction.

On the other hand, in the present embodiment, by sequentially controlling the accumulation time and signal readout of the PDIC-side pixels by four pixels over the entire pixel array portion 101, an operation close to that of a global shutter can be achieved. In addition, since the timing of the accumulation time in the vertically divided pixels 313 is the same over the entire pixel array portion 101, it is possible to suppress deterioration in accuracy of phase difference detection in the vertical direction due to the time difference in the timing of the accumulation period.

<Second Embodiment>

Next, a second embodiment of the present invention will be described.

In the first embodiment described above, the case where the number of pupil divisions is 2 has been described. However, the present invention is not limited to this, and a configuration in which the number of pupil divisions is greater than two may be employed. In the second embodiment, differences from the first embodiment will be described for the case where the number of pupil divisions is four.

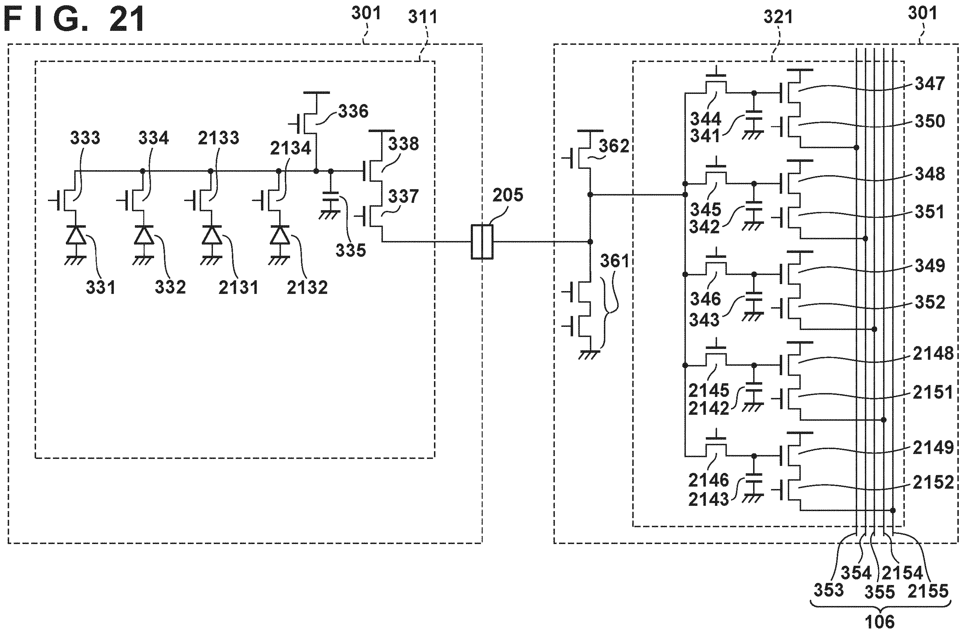

FIG. 21 is an equivalent circuit diagram of the pixel 105 according to this embodiment. Compared to the first embodiment, two photodiodes of a photodiode (PDC) 2131 and a photodiode (PDD) 2132, which are photoelectric conversion units configured in the PDIC-side pixel, are added, and a transfer transistor (TXC) 2133 and a transfer transistor (TXD) 2134 is added. Accordingly, in the MEMIC-side pixel, a signal holding capacitor (MEMC) 2142, a signal holding capacitor (MEMD) 2143, a selection switch (GSC) 2145, a selection switch (GSD) 2146, an amplification transistor (MSFC) 2148, an amplification transistor (MSFD) 2149, a signal holding capacitor selection transistor (MSELC) 2151, a signal holding capacitor selection transistor (MSELD) 2152, and output signal lines 2154 and 2155 are added.

Further, although the HB 205 shared by 2×2 pixels in the first embodiment is arranged in each pixel, it may be shared by 2×2 pixels as in the first embodiment.

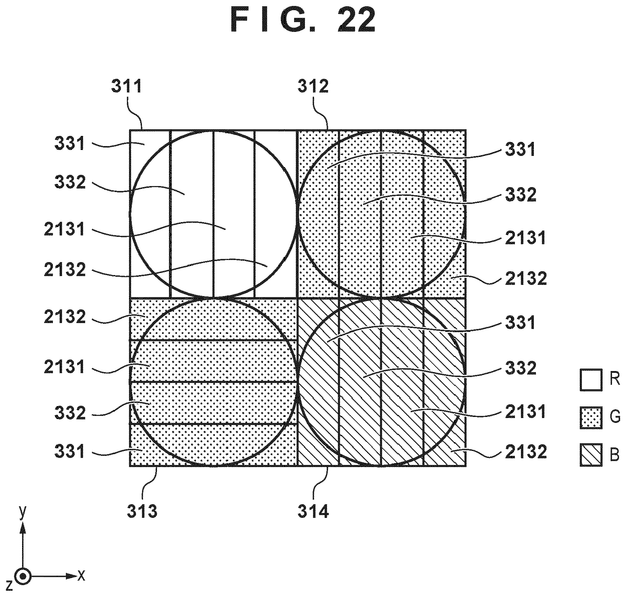

FIG. 22 is a diagram schematically showing the arrangement of the horizontally divided pixels 311, 312, 314 and the vertically divided pixel 313 and the arrangement of the color filter 806 in the range of 2×2 pixels in this embodiment. Except for the above, the configuration and control method described in the above-described first embodiment can be used, so the description thereof is omitted.

As described above, according to the second embodiment, regardless of the number of the plurality of photoelectric conversion units formed in each pixel, it is possible to suppress deterioration in accuracy of phase difference detection in the vertical direction due to the time difference in the timing of the accumulation period.

<Third Embodiment>

Next, a third embodiment of the present invention will be described.

In the first embodiment described above, the case where the repetition pattern of the color filters corresponds to that of the vertically divided pixels and horizontally divided pixels has been described. However, the present invention is not limited to this, and the arrangement of color filters may be repeated by a multiple of the repetition pattern of the vertically divided pixels and horizontally divided pixels. As the third embodiment, a case where the repetition pattern of the color filters is set to twice that of the repetition pattern of the vertically divided pixels and horizontally divided pixels will be described.

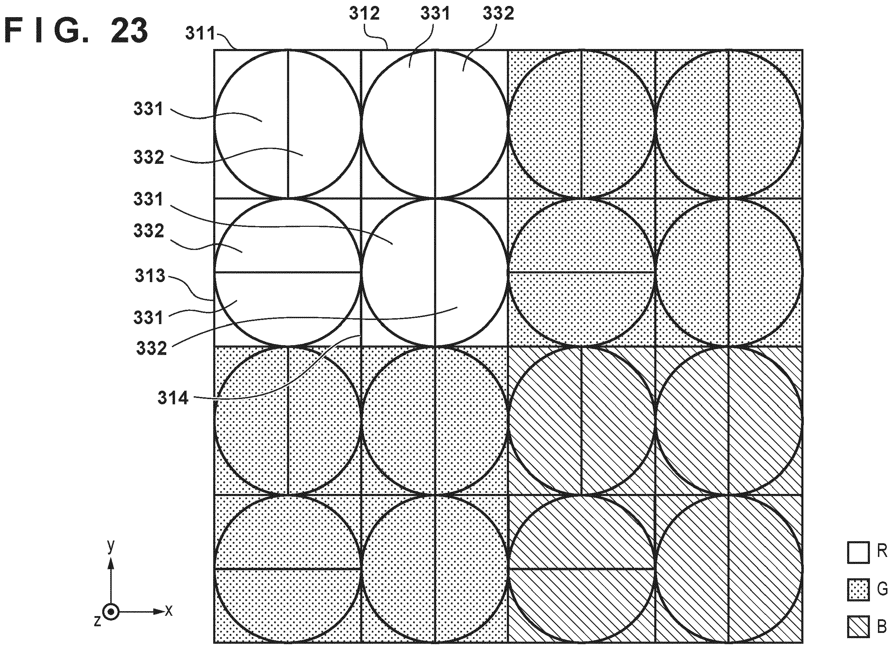

FIG. 23 is a diagram schematically showing the arrangement of the horizontally divided pixels and vertically divided pixels and the arrangement of color filters in a range of 4×4 pixels according to this embodiment. In this embodiment, adjacent 2×2 pixels have the same color filter, and color filters of 4×4 pixels form a Bayer array. Other than the above, it is the same as the first embodiment described above, so the description thereof is omitted.

As described above, according to the third embodiment, the same effects as those of the first embodiment can be obtained.

While the present invention has been described with reference to exemplary embodiments, it is to be understood that the invention is not limited to the disclosed exemplary embodiments. The scope of the following claims is to be accorded the broadest interpretation so as to encompass all such modifications and equivalent structures and functions.

An image sensor includes a plurality of pixels, and each pixel comprises: a microlens; a plurality of photoelectric conversion units that convert incident light into charge and accumulate the charge; a plurality of holding units that hold signals corresponding to the charge; control means configured to control timings of accumulating the charge converted by the plurality of photoelectric conversion units and timings of causing the plurality of holding units to hold the signals corresponding to the charge; and output means configured to output the signals held in the plurality of holding units in units of one row. The plurality of pixels include a plurality of first pixels having the plurality of photoelectric conversion units arranged in a first direction and a plurality of second pixels having the plurality of photoelectric conversion units arranged in a second direction which is perpendicular to the first direction.

**Claims**

1. An image sensor including a plurality of pixels, wherein each pixel comprises:

   a microlens;
   a plurality of photoelectric conversion units that convert incident light into charge and accumulate the charge;
   a plurality of holding units that hold signals corresponding to the charge accumulated in the plurality of photoelectric conversion units;
   control means configured to control timings of accumulating the charge converted by the plurality of photoelectric conversion units and timings of causing the plurality of holding units to hold the signals corresponding to the charge accumulated in the plurality of photoelectric conversion units; and
   output means configured to output the signals held in the plurality of holding units in units of one row,
   wherein the plurality of pixels include a plurality of first pixels having the plurality of photoelectric conversion units arranged in a first direction and a plurality of second pixels having the plurality of photoelectric conversion units arranged in a second direction which is perpendicular to the first direction.

2. The image sensor according to claim 1, wherein the control means controls so that timings of accumulating the charge in the plurality of second pixels and timings at which the signals corresponding to the charge accumulated in the plurality of photoelectric conversion units of each of the plurality of second pixels are the same for the plurality of the second pixels.

3. The image sensor according to claim 1 or 2, wherein, as the plurality of the photoelectric conversion units, the each pixel has:

a plurality of first regions formed at a first depth from a light incident surface;
a plurality of second regions formed at a second depth deeper than the first depth, for accumulating the charge generated according to the incident light; and
a plurality of connection regions that connect the plurality of first regions and the second regions.

4. The image sensor according to claim 3, wherein, among the plurality of photoelectric conversion units, the plurality of first regions of the first pixels are arranged in the first direction, and the plurality of first regions of the second pixels are arranged in the second direction.

5. The image sensor according to any one of claims 1 to 4, wherein the image sensor comprises a first semiconductor substrate including the plurality of photoelectric conversion units and a second semiconductor substrate including the plurality of holding units.

6. The image sensor according to claim 5, wherein the signals corresponding to the charge are held in the plurality of holding units via connecting points each provided for every predetermined number of pixels between the first semiconductor substrate and the second semiconductor substrate.

7. The image sensor according to claim 5, wherein the signals corresponding to the charge are held in the plurality of holding units via connecting points each provided for each pixel between the first semiconductor substrate and the second semiconductor substrate.

8. The image sensor according to any one of claims 1 to 7, wherein the each pixel is covered with a color filter of one of a plurality of colors formed between the microlens and the plurality of photoelectric conversion units, and
the second pixels are covered with the color filters of a predetermined color.

9. The image sensor according to any one of claims 1 to 7, wherein the each pixel is covered with a color filter formed between the microlens and the plurality of photoelectric conversion units, and
the color filters are of Bayer arrangement, and a set of color filters of the Bayer arrangement are provided for a predetermined number of pixels including the second pixel.

10. The image sensor according to any one of claims 1 to 9, wherein the plurality of holding units are trench MOS type.

11. An image capturing apparatus comprising:

the image sensor according to any one of claims 1 to 10; and
a focus detection unit that performs phase difference focus detection based on the signals output from the plurality of holding units.

# F I G. 1

# F I G. 2

FIG. 3

# F I G. 4A

# F I G. 4B

READ OUT SIGNAL FROM PDIC-SIDE PIXEL 312

READ OUT SIGNAL FROM PDIC-SIDE PIXEL 313

READ OUT SIGNAL FROM PDIC-SIDE PIXEL 314

# FIG. 5

# F I G. 6

READ OUT SIGNALS
FROM PDIC-SIDE
PIXELS TO
MEMIC-SIDE PIXELS

RESET PD

READ OUT SIGNALS
FROM MEMIC-SIDE
PIXELS TO COLUMN
ACCUMULATION PERIOD      CIRCUITS

TIME

ROW
NUMBER

# F I G. 7

# F I G. 8A

# F I G. 8B

# FIG. 8C

FIG. 9A    FIG. 9B    FIG. 9C    FIG. 9D

EP 4 373 120 A1

# FIG. 10

EP 4 373 120 A1

# FIG. 11A

703 704

335

804

711 712

715 714

713

716

x

y

z

# FIG. 11B

703 335 704

715 714

711 712

713 716

z⊗ →x

y

⟷

1101

# FIG. 11C

803

802

z⊗ →x

y

EP 4 373 120 A1

# F I G.  13

# FIG. 14

# F I G. 15

# F I G. 16

# F I G. 17

# FIG. 18

SIGNAL
INTENSITY

1802

1801

Xp

# FIG. 19

1902

1901

Ds

1700

# F I G. 20

FIG. 21

# F I G. 22

| | R |
| --- | --- |
| | G |
| | B |

EP 4 373 120 A1

FIG. 23

Europäisches
Patentamt

European
Patent Office

Office européen
des brevets

# EUROPEAN SEARCH REPORT

Application Number

EP 23 20 6988

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2020/358971 A1 (SHIM EUNSUB [KR] ET AL) 12 November 2020 (2020-11-12) | 1,2,11 | INV. H04N23/67 |
| Y | * abstract * * paragraphs [3143], [0044], [0045] * * figures 1,2,5,3A,3B * | 3-7,9,10 | H01L27/146 H04N25/13 H04N25/704 H04N25/778 |
| X | US 2019/104261 A1 (HATAKEYAMA RYO [JP]) 4 April 2019 (2019-04-04) | 1,2,8,9, 11 | H04N25/79 H04N25/78 |
| Y | * abstract * * paragraphs [0065], [0081], [0102] * * figures 4,5 * | 3-7,9,10 | H04N25/589 H04N25/616 H04N25/771 |
| Y | EP 3 951 878 A2 (CANON KK [JP]) 9 February 2022 (2022-02-09) * abstract * * paragraphs [0039], [0058] * * figures 8A,8B * | 3,4 | |
| Y | US 2018/295303 A1 (MURAO FUMIHIDE [JP]) 11 October 2018 (2018-10-11) * abstract * * figures 18,20 * | 5-7 | TECHNICAL FIELDS SEARCHED (IPC) |
| Y | US 2012/267511 A1 (KOZLOWSKI LESTER [US]) 25 October 2012 (2012-10-25) * abstract * * paragraphs [0027], [0037], [0048] * | 10 | H04N H01L |

The present search report has been drawn up for all claims

| Place of search | Date of completion of the search | Examiner |
|---|---|---|
| Munich | 2 April 2024 | Lauri, Lauro |

## ANNEX TO THE EUROPEAN SEARCH REPORT
## ON EUROPEAN PATENT APPLICATION NO.

EP 23 20 6988

This annex lists the patent family members relating to the patent documents cited in the above-mentioned European search report.
The members are as contained in the European Patent Office EDP file on
The European Patent Office is in no way liable for these particulars which are merely given for the purpose of information.

02-04-2024

| Patent document cited in search report | | Publication date | Patent family member(s) | | Publication date |
|---|---|---|---|---|---|
| US 2020358971 | A1 | 12-11-2020 | CN | 111916468 A | 10-11-2020 |
| | | | US | 2020358971 A1 | 12-11-2020 |
| | | | US | 2022337772 A1 | 20-10-2022 |
| US 2019104261 | A1 | 04-04-2019 | JP | 6944846 B2 | 06-10-2021 |
| | | | JP | 2019068351 A | 25-04-2019 |
| | | | US | 2019104261 A1 | 04-04-2019 |
| EP 3951878 | A2 | 09-02-2022 | CN | 114070976 A | 18-02-2022 |
| | | | EP | 3951878 A2 | 09-02-2022 |
| | | | JP | 2022189971 A | 22-12-2022 |
| | | | US | 2022046178 A1 | 10-02-2022 |
| US 2018295303 | A1 | 11-10-2018 | JP | 2018182462 A | 15-11-2018 |
| | | | US | 2018295303 A1 | 11-10-2018 |
| US 2012267511 | A1 | 25-10-2012 | CN | 103782582 A | 07-05-2014 |
| | | | CN | 106449677 A | 22-02-2017 |
| | | | CN | 106449678 A | 22-02-2017 |
| | | | CN | 106449679 A | 22-02-2017 |
| | | | CN | 106454157 A | 22-02-2017 |
| | | | CN | 106454163 A | 22-02-2017 |
| | | | EP | 2700220 A1 | 26-02-2014 |
| | | | EP | 3062344 A1 | 31-08-2016 |
| | | | EP | 3062345 A1 | 31-08-2016 |
| | | | EP | 3062346 A1 | 31-08-2016 |
| | | | EP | 3062347 A1 | 31-08-2016 |
| | | | EP | 3067932 A1 | 14-09-2016 |
| | | | KR | 20140041492 A | 04-04-2014 |
| | | | KR | 20160108580 A | 19-09-2016 |
| | | | KR | 20160108581 A | 19-09-2016 |
| | | | KR | 20160108582 A | 19-09-2016 |
| | | | KR | 20160108583 A | 19-09-2016 |
| | | | TW | 201301491 A | 01-01-2013 |
| | | | TW | 201717381 A | 16-05-2017 |
| | | | TW | 201824856 A | 01-07-2018 |
| | | | US | 2012267511 A1 | 25-10-2012 |
| | | | US | 2013334403 A1 | 19-12-2013 |
| | | | US | 2015194456 A1 | 09-07-2015 |
| | | | US | 2016093655 A1 | 31-03-2016 |
| | | | US | 2016099276 A1 | 07-04-2016 |
| | | | WO | 2012161847 A1 | 29-11-2012 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 58024105 A
- JP 2011053519 A

- JP 2021068758 A